# EUROPÄISCHE PATENTSCHRIFT

(11) **EP 0 565 667 B1**
(45) Veröffentlichungstag und Bekanntmachung des Hinweises auf die Patenterteilung: **10.09.1997**
(21) Anmeldenummer: 92921758.6
(22) Anmeldetag: 30.10.1992
(51) Int. Cl.: H03K 17/732

(54) **GTO-THYRISTORSCHALTUNG**
GTO THYRISTOR CIRCUIT
CIRCUIT A THYRISTORS GTO

(30) Priorität: 02.11.1991 DE 4136181
(43) Veröffentlichungstag der Anmeldung: 20.10.1993
(73) Patentinhaber: ABB RESEARCH LTD., 8050 Zürich (CH)
(72) Erfinder: GRÜNING, Horst, CH-5430 Wettingen (CH)
(74) Vertreter: Lück, Gert, Dr.
(86) Internationale Anmeldenummer: CH9200222
(87) Internationale Veröffentlichungsnummer: WO9309600

(56) Entgegenhaltungen:
- EP-A- 0 328 778
- WO-A-91/04608
- DE-A- 4 012 843

## Beschreibung

### TECHNISCHES GEBIET

Die vorliegende Erfindung bezieht sich auf das Gebiet der Leistungselektronik. Sie betrifft eine GTO-Thyristorschaltung nach dem Oberbegriff des ersten Anspruchs.

### STAND DER TECHNIK

Eine solche Schaltung ist beispielsweise aus der EP-A3- 0 228 226 oder der WO 91/04608 bekannt. Die WO 91/04608 lehrt zusätzlich zur vorstehend genannten Schrift noch die Verwendung eines Nachladekreises, der die Gatespannung während des gesamten Abschaltens auf einem bestimmten Wert hält.

Heute sind auf dem Markt eine Vielzahl von etwa 190 GTO-Typen erhältlich. In der Anwendung teilen sie sich im wesentlichen auf drei wichtige Einsatzgebiete auf, nämlich die Traktion (z.B. in elektrischen Lokomotiven), die USV (unterbrechungsfreie Stromversorgung) und industrielle Antriebe. Diese weite Verbreitung hat stattgefunden, obwohl der GTO für den Anwender z.B. schaltungstechnisch mit einigen Problemen behaftet ist. Einer Verbesserung des GTO selbst bzw. einer Vereinfachung dessen äusserer Beschaltung kommt deshalb eine enorme wirtschaftliche Bedeutung zu.

Der Anwender sieht sich im Zusammenhang mit dem GTO insbesondere mit folgenden Problemkreisen konfrontiert:
- Aufwand in der Ansteuerung;
- Ausschaltausfälle;
- Einhalten der Spike-Spannung;
- Schaltverluste im GTO und in der Beschaltung;
- Kühlung.

Abschaltbare Thyristoren (GTOs) müssen bislang mit erheblichen Beschaltungsnetzwerken aus Dioden, Induktivitäten und Kapazitäten (Snubbern) betrieben werden, um kritische Zustände für das Bauelement sicher zu vermeiden. Neben Mehrgewicht, erhöhtem Volumen und beträchtlichen Verlusten zieht dies insbesondere zusätzliche Entwicklungs- und Herstellungskosten nach sich. Auch die Entwicklung von Steuersoftware ist durch die von den Snubbern bestimmte, komplizierte Betriebsweise deutlich aufwendiger. Man ist deshalb bestrebt, die Snubber zu verkleinern (kleinere Induktivitäten und kleinere Kapazitäten) und zu vereinfachen.

Eine wichtige Rolle spielen dabei insbesondere die Streuinduktivität der Anordnung und die Snubberdiode. Zur Verringerung von Ueberspannungen durch Induktivitäten muss ein erheblicher konstruktiver Aufwand betrieben werden.

Es sind in jüngerer Zeit auch ganz spezielle Dioden für diese Anwendungen entwickelt worden.

Der Grund für die benötigten Snubber liegt anerkanntermassen im nichthomogenen Ein- und Abschalten der GTOs: Eine Vielzahl von Studien mit Infrarot-, Wärme- und Induktionsmessungen haben immer wieder diesen Tatbestand hervorgehoben. Man hat deshalb die Anstrengungen auf die Herstellung von (insbesondere bezüglich der Dotierung) möglichst homogenen Bauelementen gerichtet. Trotz markanten Verbesserungen der Dotierungshomogenität konnten die Snubber aber nicht wesentlich vereinfacht oder verkleinert werden.

Das erklärte Wunschziel von Anwendern und Herstellern ist ein schnell schaltbarer, sogenannter HF-GTO. Dieser soll sich unter anderem auszeichnen durch einen deutlich geringeren Beschaltungsaufwand, durch geringe Ansteuerleistung und geringe Ausschaltausfälle. Zur Realisierung eines solchen HF-GTO ist in der älteren Europäischen Anmeldung Nr. 90123659.6 (veröffentlicht als EP-A 0 485 945) von demselben Erfinder bereits eine Schaltanordnung zur harten Ansteuerung vorgeschlagen worden, bei der das Abschalten durch einen impulsförmigen, den Anodenstrom schnell (in wenigen µs) übersteigenden Gatestrom bewirkt wird.

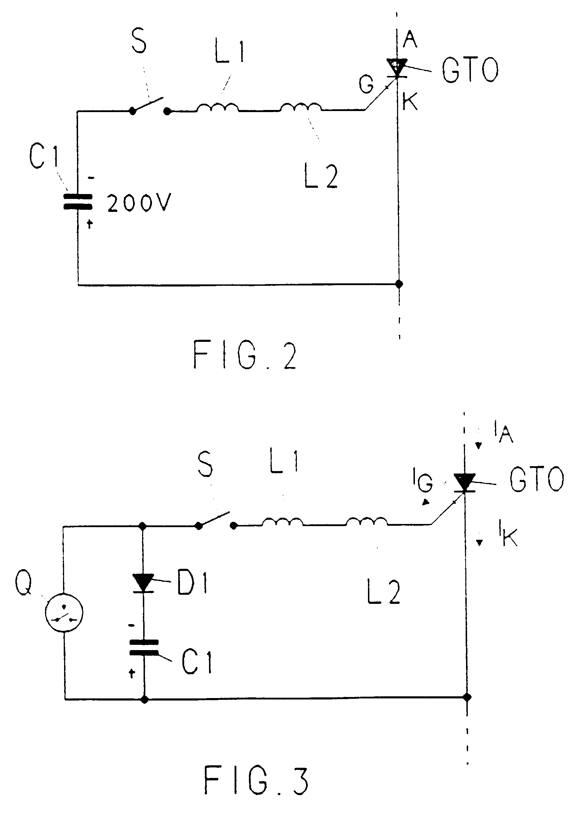

Die Fig. 3 der älteren Anmeldung zeigt schematisch eine geeignete Gatebeschaltung für einen GTO bekannter Bauart. Die Gatebeschaltung umfasst dabei
- eine relativ geringe Gatekreisinduktivität LG zwischen einem Schalter GU und dem Gateanschluss des GTO-Bauelements;
- eine erste Kapazität CR1 hoher Spannung zwischen dem Schalter GU und dem Kathodenanschluss des GTO; und
- parallel zur ersten Kapazität CR1 eine zweite Kapazität CE1 niederer Spannung und eine zu CE1 vorgeschaltete Diode D1 zum Trennen der Kondensatorspannungen.

Die Gatekreisinduktivität ist dabei vorgegeben durch die bei herkömmlichen Gehäusebauarten unvermeidliche Induktivität. Die Schaltung arbeitet in einem quasiresonanten Betriebsmodus: Die kleine erste Kapazität CR1 mit hoher Spannung (vorzugsweise ≥ 100 V, z.B. 200 V), liefert zu Beginn einen trotz der vorhandenen Gatekreisinduktivität schnell ansteigenden Gatestrom, der nach dem Entladen von der zweiten Kapazität (dem Erhaltungskondensator) CE1 über eine längere Zeit (Dauer des Abschaltvorgangs) aufrechterhalten wird. Die Kapazität CR1 wird (unter Berücksichtigung der tatsächlichen Induktivität im GTO-Gehäuse) so bemessen, dass sie nach Entladung einen Gatestrom aufgebaut hat, der dem maximal abschaltbaren Anodenstron entspricht. Der relativ lang anhaltende Strom aus CE1 muss mit einer Spannung angeboten werden, die unterhalb des Avalanche der Gate-Kathodenstrecke (15 - 25 V) liegt.

Es wird auf diese Weise ein Gatestrom angeboten, der genügend hoch und schnell ist, so dass der Kathodenstron unter allen Umständen kleiner null ist. Mit der länger anhaltenden niedrigen Spannung kann vermieden werden, dass der Gatestrom beim Schalten zusammenbricht und das Bauelement einen kritischen Zustand gerät.

Obgleich damit in der älteren Anmeldung eine für die harte Ansteuerung geeignete Gatebeschaltung im Prinzip bereits angegeben ist, wird nicht offenbart, wie z.B. der kritische Uebergang dieser Schaltung vom Ausräumbetrieb (Absaugen der Ladungsträger aus der Gate-Kathodenstrecke) in den statischen Haltebetrieb bewerkstelligt wird. Um die gestellte Aufgabe deutlich zu machen, sollen nachfolgend zunächst noch einmal die Randbedingungen für einen hart angesteuerten HF-GTO oder HD(Hard Driven)-GTO präzisiert werden:

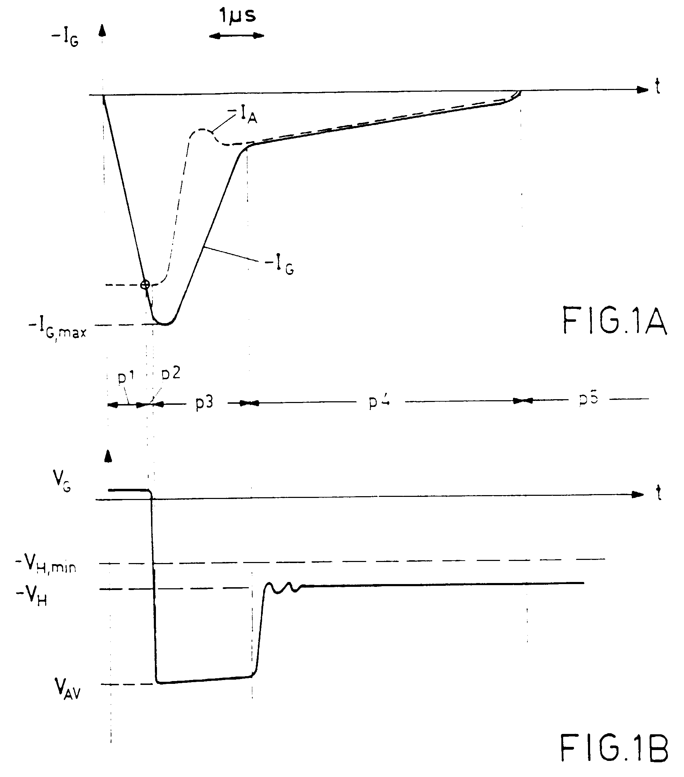

Zum bestmöglichen Abschalten soll (Fig. 1A und 1B) der Gatestrom I_{G} in einer ersten Phase pl schnell ansteigen, bis er in einer zweiten Phase p2 den Anodenstrom I_{A} übersteigt und folglich den Kathodenstrom (in der Figur nicht dargestellt) reversiert. Hat der Kathodenstrom sein Vorzeichen gewechselt, wird in einer dritten Phase p3 das Plasma der Gate-Kathodenstrecke abgesogen und der zugehörige pn-Uebergang (Gatespannung V_{G}) nimmt die Avalanchespannung V_{AV} auf. Er behält die Avalanchespannung V_{AV} bei, solange der Gatestrom I_{G} grösser als der Anodenstrom I_{A} (Tailstrom) ist, und muss danach so auf einen kleineren, zum Blockieren ausreichenden Wert zurückgeführt werden, dass die innere Gatespannung in einer vierten Phase p4 niemals unter eine kritische Grenze (die minimale Haltespannung V_{H,min}) fällt. Danach muss eine fünfte Phase p5, die Haltephase, folgen, während der die Gatespannung auf Off-Potential (Haltespannung V_{H}) gehalten wird.

Im Prinzip würde es also genügen, wenn die Gatespannung an der Siliziumscheibe des GTO (innere Gatespannung) bereits nach vollzogenem Ausräumvorgang auf den zweiten, zum Blockieren ausreichenden Wert, die Haltespannung V_{H}, gebracht würde. Dann nämlich könnte die dritte Phase p3 entfallen, und der Energieverbrauch der Gatebeschaltung wäre auf ein notwendiges Minimum reduziert. Statt der Stromsteuerung wäre dazu aber eine Spannungssteuerung nötig, d.h., die direkte Kontrolle der inneren Gatespannung durch eine entsprechend stabile Spannungsquelle. Bei einem GTO im Standardgehäuse ist dies aber aufgrund der Leitungsinduktivität nicht möglich, denn statt der tatsächlichen 30 nH - 50 nH müsste man eine Gatekreisinduktivität von maximal 1 nH realisieren (es sind dI/dt > 5 kA/µs gemessen worden entsprechend 5 V an 1 nH).

Die Bedingungen bei der GTO-Ansteuerung liegen damit anders: Während der ersten Phase pl muss Stromsteuerung erfolgen, da zur Erzielung eines dI/dt > 2 kA/µs (3 kA-GTO; Abschaltbedingung nach 1µs erreicht) - wie bereits erwähnt - eine weit grössere Spannung notwendig ist als die Haltespannung V_{H} aus der vierten Phase p4 (typ. -15 V). Wie schon in der genannten älteren Anmeldung beschrieben, wird die Energie dazu am einfachsten gemäss Fig. 2 aus einer Kondensatorentladung entnommen. Dazu ist eine erste Kapazität C1 über einen Schalter S, die Zuleitungsinduktivität L1 und die innere Induktivität L2 des GTO an Gate G und Kathode K des GTO angeschlossen.

Bevor sich aber der Strom in dem sich ergebenden Schwingkreis (aus der ersten Kapazität C1, der Leitungsinduktivität L1 und der inneren Induktivität L2) nach der ersten Halbperiode umkehrt, muss die erste Kapazität C1 abgekoppelt werden. Dies könnte beispielsweise durch eine Diode D1 (Fig. 3) geschehen, die zu der ersten Kapazität C1 in Serie geschaltet ist. C1 wird dann umgeladen und der Strom nach dem Durchlaufen des Dioden-Recovery (Vorsicht! Kurzfristig umgekehrter Strom!) unterbrochen. In diesem Falle muss eine zusätzliche Quelle Q bereits vor Unterschreiten des Tailstromes zugeschaltet werden, damit die innere Gatespannung am GTO nicht kurzfristig zusammenbricht. Es würden eine aufwendige Zeitsteuerung und ein weiterer niederinduktiver Kreis notwendig, ohne dass das Problem des Uebergangs in den nachfolgenden Haltezustand gelöst wäre.

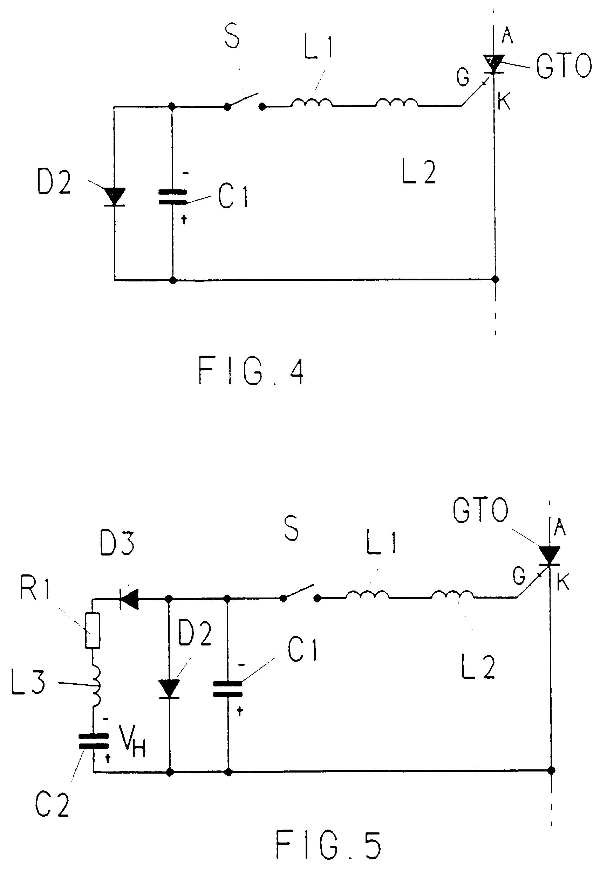

Besser wäre es deshalb, die Abkopplung bereits beim Durchlaufen des Strommaximums (des maximalen Gatestroms I_{G,max} in Fig. 1A) durchzuführen (Kondensatorspannung 0). Dazu wird beispielsweise der ersten Kapazität C1 gemäss Fig. 4 eine erste Diode D2 antiparallel geschaltet. Einzig die innere Gatespannung und die Verluste im Schalter S, in der ersten Diode D2 und im Gatekreis addieren sich dann zur Gegenspannung an der Kreisinduktivität (L1 + L2), d.h., der Gatestrom I_{G} nimmt im Allgemeinen deutlich langsamer ab, als er angestiegen ist (Phase p3 in Fig. 1A). Damit ist sichergestellt, dass der Gatestrom I_{G} während der Fallphase (Anodenstrom I_{A} fällt zurück auf den Tailstromwert) grösser ist als der Anodenstrom I_{A}.

Doch selbst dann wäre es nicht leicht, den richtigen Zeitpunkt für das Einschalten einer Haltestromquelle zu definieren (Unterschreiten des Anodenstroms I_{A}). Und wegen des noch immer hohen dI/dt müsste auch diese Quelle stromgesteuert sein, und der Uebergang zur endgültigen Spannungssteuerung in der Haltephase p4 wäre nur vertagt.

### DARSTELLUNG DER ERFINDUNG

Es ist daher Aufgabe der Erfindung, eine konventionelle Gatebeschaltung so weiterzubilden, dass sie für die harte Ansteuerung eines GTOs verwendet werden kann, die aber auch einfach aufgebaut und einfach anzusteuern ist. Ausserdem sollen beim Abschaltvorgang ein Übergang von der Stromsteuerung auf einer Spannungssteuerung ermöglicht werden, ohne dass parasitäre Induktivitäten und Recovery-Vorgänge störenden Einfluss nehmen.

Diese Aufgabe wird bei einer Vorrichtung der eingangs genannten Art durch die Merkmale des ersten Anspruchs gelöst.

Weitere Ausführungsformen ergeben sich aus den abhängigen Ansprüchen.

### KURZE BESCHREIBUNG DER ZEICHNUNG

Die Erfindung soll nachfolgend anhand von Ausführungsbeispielen im Zusammenhang mit der Zeichnung näher erläutert werden. Es zeigen
- Fig. 1A,B: den gewünschten schematischen Verlauf von Anodenstrom, Gatestrom und Gatespannung über der Zeit beim harten Abschalten eines GTO;
- Fig. 2: das Prinzipschema zur resonanten Erzeugung eines Gatestromimpulses für das harte Abschalten eines GTO;
- Fig. 3: das Prinzipschema eines möglichen Uebergangs von der Stromsteuerung gemäss Fig. 2 in der Ausräumphase zur Spannungsteuerung in der Haltephase durch Abkoppeln der ersten Kapazität;
- Fig. 4: eine zu Fig. 3 alternative Art der Abkopplung der ersten Kapazität;
- Fig. 5: ein erstes Ausführungsbeispiel für eine GTO-Ansteuerung nach der Erfindung;
- Fig. 6A: Simulationsergebnisse für den Verlauf des Gatestroms, der Gatespannung und der Spannung an der ersten Kapazität über der Zeit für eine Schaltung gemäss Fig. 5;
- Fig. 6B: Simulationsergebnisse für den Verlauf des Gatestroms, der Gatespannung und des Stromes und der Ladungsänderung der zweiten Kapazität über der Zeit für eine Schaltung gemäss Fig. 5;

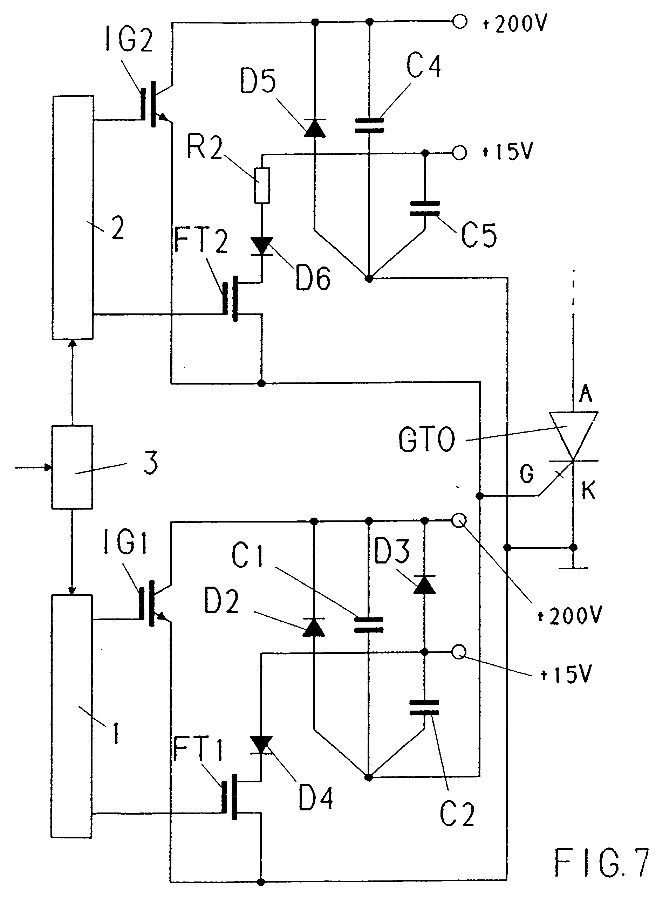

- Fig. 7: einen beispielhaften vollständigen Aufbau einer Gatebeschaltung nach der Erfindung für das Ein-und Ausschalten.

### WEGE ZUR AUSFÜHRUNG DER ERFINDUNG

Während die Figuren 1 bis 4 bereits im Zusammenhang mit der dieser Erfindung zugrundeliegenden Problemstellung in der Einleitung erläutert worden sind, zeigt Fig. 5 ein erstes bevorzugtes Ausführungsbeispiel für eine GTO-Thyristorschaltung nach der Erfindung.

Zentrales Bauelement ist hier wiederum ein GTO mit Anode A, Kathode K und Gate G, der durch einen Gatekreis angesteuert wird. Der Gatekreis enthält - wie bereits im Zusammenhang mit Fig. 4 beschrieben - die beiden Induktivitäten L1 (Leitungsinduktivität) und L2 (innere Induktivität des GTO), die über einen Schalter S in Serie liegende erste Kapazität C1 und die dazu antiparallele erste Diode D2. Die Grössen der ersten Kapazität C1 und der ersten Induktivität L1 sind so gewählt sind, dass bei einer Entladung der ersten Kapazität C1 über die beiden Induktivitäten L1, L2 der aus der ersten Kapazität C1 stammende Gatestrom I_{G} in der ersten Viertelschwingung des Serie-Schwingkreises das 0,5fache eines abzuschaltenden Anodenstroms I_{A} des GTO innerhalb von weniger als 5 µs, vorzugsweise weniger als 2 µs, übersteigt.

Parallel zu der ersten Kapazität C1 ist ein Nachladekreis mit einer Serieschaltung aus einer zweiten, auf die Haltespannung V_{H} vorgeladenen Kapazität C2 (im Beispiel 16 mF), einer dritten Induktivität L3 (im Beispiel 5 nH), einem ersten Widerstand R1 (im Beispiel 5 mΩ) und einer zweiten Diode D3 geschaltet.

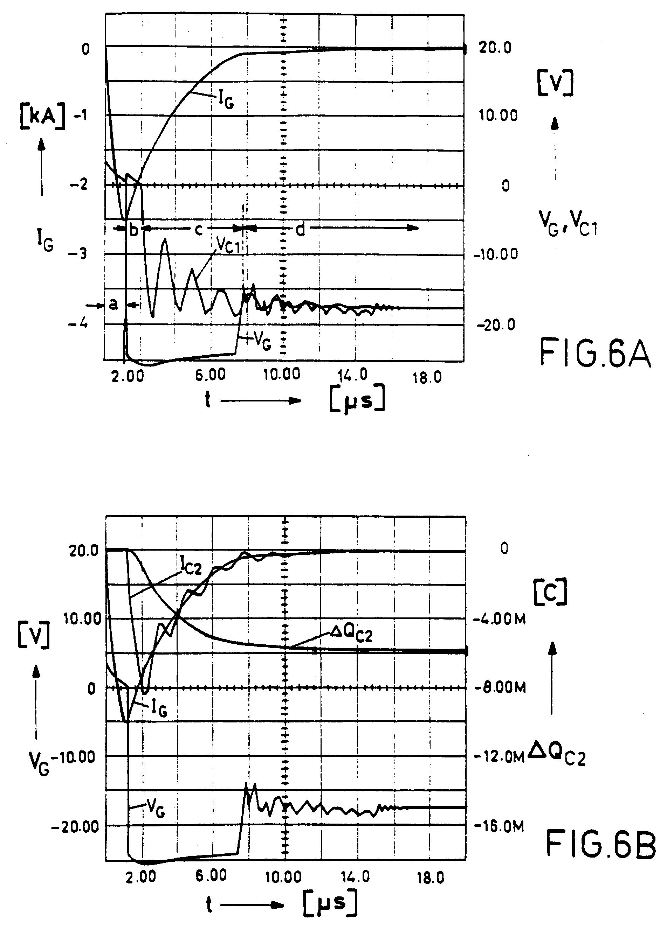

Die Funktion der Schaltung kann anhand der Figuren 6A und 6B erläutert werden, die den zeitlichen Verlauf verschiedener Ströme, Spannungen und Ladungen innerhalb der Schaltung während verschiedener Phasen a bis d des Abschaltvorgangs für die o.g. Bauelementwerte wiedergeben. I_{G} und V_{G} bezeichnen dabei wie gehabt den Gatestrom bzw. die Gatespannung, V_{C1} die Spannung an der ersten Kapazität C1, und I_{C2} und DELTAQ_{C2} den Strom bzw. die Ladungsänderung der zweiten Kapazität C2.

In einer ersten Phase a wird die erste Kapazität C1 über den geschlossenen Schalter S und die Induktivitäten L1 und L2 resonant entladen. Der resultierende Gatestrom I_{G} wächst dabei am Ende der ersten Viertelperiode der Schwingung auf seinen Maximalwert. Die Phasen p1 und p2 aus Fig. 1A und 1B fallen also in diese Zeitspanne.

Während der Phase b ist der Gatestrom derart gross, dass die erste Kapazität C1 nicht nachgeladen werden kann. Die Spannung v_{C1} bricht deshalb auf die Flussspannung der ersten Diode D2 zusammen. Dies aber ist der Auslöser für das Aufbauen des Stromes im Nachladekreis (repräsentiert durch den Strom I_{C2}). Sobald I_{C2} genügend gross gegenüber I_{G} ist, wird die erste Kapazität C1 geladen (Phase c). Die innere Gatespannung des GTO bleibt weiterhin auf dem Avalanchewert, solange der Gatestrom I_{G} grösser als der Anodenstrom (Tailstrom) ist. Danach fällt die innere Gatespannung auf den Haltewert zurück (Phase d), und der Kathodenstrom (= Anodenstrom minus Gatestrom) sinkt auf Null.

Dieser kritische Uebergang am Beginn der Phase d führt zu Oszillationen, die einerseits von der Abrisscharakteristik des GTO und seinen parasitären Gatekapazitäten, und die andererseits durch L1, L2 und C1 bestimmt werden. Sowohl die Widerstände im Gatekreis (z.B. der innere Widerstand des Schalters S) als auch die Widerstände des Nachladekreises wirken hier dämpfend. Da hier R1 besonders dominant ist, ist dieses Ausführungsbeispiel besonders zu bevorzugen.

Weiterhin ist die Dimensionierung des Nachladekreises wichtig: Obwohl der Strom I_{C2} verzögert einsetzen darf und nur Werte geringfügig (z.B. um einen Faktor 1,5) über dem Tailstrom haben muss, ist zur Dämpfung von Schwingungen zwischen C2, L3, R1 und D3 (die Diode D3 ist vorgespannt und daher dauernd leitend!) und C1 ein kleines L3 und ein entsprechend dem notwendigen Strom möglichst gross dimensioniertes Rl notwendig (die o.g. Werte gelten für einen GTO mit 3 kA und 4,5 kV). Solche Werte erzielt man vorzugsweise durch Parallelschalten mehrerer Teilkreise (L3 = 5 nH) und Einbeziehen der parasitären Widerstände in den Kondensatoren (R1 = 5 mΩ ergibt sich als interner Widerstand bei geeigneter Wahl der Kondensatoren als Elektrolytkondensatoren). Generell kann gesagt werden, dass der Wert von R1 so gewählt sein soll, dass ein aus der zweiten Kapazität C2 gespeister Strom einerseits kleiner ist als der maximale Gatestrom (I_{G,max}) und andererseits grösser ist als der Tailstrom des GTO.

Darüberhinaus muss von der zweiten Diode D3 kein speziell schnelles Verhalten gefordert werden: Das Forward-Recovery wirkt ausschliesslich verzögernd und vermindert dadurch sogar noch die aus dem Nachladekreis in der Phase b unwirksam eingespeiste Ladung. Vorzugsweise werden hier also langsame Dioden verwendet - die äusserst günstige Diode vom Typ 1N4007 hat sich hier in der Parallelschaltung bestens bewährt.

Während bei den bisherigen Ausführungen nur auf die Abschaltphase eingegangen worden ist, lässt sich die gesamte Zustandsfolge für den Schaltvorgang eines GTO in vier Abschnitte unterteilen: (1) Einschalten, (2) On-Zu-stand halten, (3) Abschalten, (4) Off-Zustand halten. Im Prinzip könnte man dabei jeweils (1) und (2) sowie (3) und (4) direkt ineinander übergehen lassen, also die gleiche Schaltung wie oben beschrieben nicht nur zum Abschalten, sondern auch zum Erhalten des Off-Zustands verwenden.

Eine direkte Folge davon wäre aber, dass die zugehörigen Pulskondensatoren solange entladen blieben. Sie könnten also nur während der On-Phase geladen werden. Dies würde sowohl zu einer Verlängerung dieser Phase bis zum Beenden des Ladens der Ausschaltkondensatoren als auch zu einem hohen Ladestrom für das Beschleunigen des Ladevorgangs führen. Erschwerend käme hinzu, dass die Pulskondensatoren während der Off-Phase vom Netz getrennt werden müssten, damit nicht ein unnötig hoher Strom während langer Zeit (der Off-Zeit) in einen Kurzschluss flösse. Aufwand und Nutzen stehen daher bei dieser Art des Betriebes in einem ungünstigen Verhältnis zueinander.

Deshalb wird ein Viertaktverfahren mit der oben definierten Folge der Zustände (1) - (2) - (3) - (4) vorgeschlagen, wobei jeweils getrennte Schalter während der Perioden den Kontakt zum Gate G des GTO herstellen. Die Perioden (1) und (3) können dann kurz gewählt werden (typ. 10 - 30 µs). Während der Perioden (2) und (4) fliesst nur ein geringer Haltestrom (einige A in (2), damit - wie bekannt - ein Löschen des GTO verhindert wird, und wenige mA Leckstrom in (4)). Die Nachladung der Pulskondensatoren erfolgt dann praktisch während der gesamten Zykluszeit (= 1/f - (10-30µs)). Vorzugsweise erfolgt sie speziell bei dem grossen Abschaltkondensator (Kapazität C1; typ. 200 V, 20 µF für einen GTO mit 3 kA und 4,5 kV) zwecks Energieersparnis durch einen Chopper.

Speziell bei den hier schwerpunktsmässig betrachteten grossen GTO mit typ. 3 kA und 4,5 kV sind beim Ausschalten entsprechend grosse Gateströme erforderlich. Im Prinzip könnten dabei als Schalter S im Gatekreis Thyristoren eingesetzt werden. Diese schalten jedoch aufgrund ihrer immanenten Plasmaausbreitung verhältnismässig langsam ein. Sie tragen damit sowohl zu einer unerwünschten Begrenzung der Stromsteilheit dI/dt im Gate G des GTO bei als auch verursachen sie erhöhte Verluste in der Gateeinheit.

Es werden deshalb besonders die folgenden Varianten für den Schalter S in Fig. 5 vorgeschlagen:
(a) eine Parallelschaltung von MOSFETs
   Die Geschwindigkeit ist sehr gut. Allerdings ist der Aufwand hoch (typ. sind Werte von nur 100A/MOSFET) und die Parallelschaltung ist aufgrund der Sourcedraht-Induktivitäten recht heikel (es können Transienten an diesen Induktivitäten entstehen (4 kA/µs x 10 nH = 40 V!), die zur Gefährdung oder Zerstörung der MOSFETs führen).
(b) eine Parallelschaltung von IGBTs
   Die Probleme sind hier ähnlich wie bei den MOSFETs, jedoch werden 3-4mal weniger Elemente benötigt, da die Stromtragfähigkeit aufgrund der Ladungsträgerinjektion grösser und die Verluste geringer sind. Es ist also auf eine optimale Leiterbahnführung und Entkopplung der Gates (Widerstände) zu achten.
(c) feinstrukturierter Thyristor oder GTO mit harter Einschaltsteuerung
   Aehnlich wie im Hauptkreis kann man das im Gatekreis notwendige dI/dt > einige kA/µs auch durch ein hartes Einschalten eines GTO erzielen. Unterstützend dabei wirkt, dass ein solches Element bei der bevorzugten Ausführungsform nur etwa 500 V Sperrspannung aufweisen muss. Die Mittelzone kann deshalb weit dünner (EPI) als beim Haupt-GTO ausgelegt werden. Somit ergeben sich sowohl ein schnelleres Einschalten (weniger gespeicherte Ladung) als auch weit grössere Spitzenstromdichten (bis über 1000 A/cm²). Daraus resultieren sehr kleine Elemente mit anspruchsloser Ansteuerung (< 100 A für 3 kA beim Haupt-GTO). Bei einer niederinduktiven Verbindungstechnik reichen deshalb wenige Niedervolt-MOSFETs zum Ansteuern aus.
(d) SITh, FCTh oder ähnliches
   Selbstverständlich können auch feldgesteuerte bipolare Elemente zum Einschalten des Gatestromes verwendet werden. Zumindest derzeit fehlt es aber noch an der Verfügbarkeit solcher Bauelemente.

Die Randbedingungen für die Wahl der Kondensatoren für C1 bis C2 ergeben sich aus der Anwendung. Für GTOs mit 3 kA und 4,5 kV müssen Pulsströme von über 3 kA bereitgestellt werden, wobei die Kapazitäten sich im Zeitbereich von 1 - 3 µs entladen (für dI/dt = 3 - 1 kA/µs). Die Betriebsspannung beträgt dabei vorzugsweise ca. 200 V.

Im Prinzip könnten hier also z.B. pulsstromfeste GTO-Snubberkondensatoren Verwendung finden, jedoch sprengen Kosten und Platzbedarf jeden vernünftigen Rahmen. Es wird deshalb bevorzugt der Einsatz von keramischen Vielschichtkondensatoren vorgeschlagen. Bei eingeschränktem Arbeitstemperaturbereich könnten überdies MKT-Vielschichtkondensatoren verwendet werden.

Ein bevorzugtes Ausführungsbeispiel für die gesamte Gatebeschaltung eines GTO (Ein- und Ausschalten) ist in Fig. 9 dargestellt. Sie umfasst zwei weitgehend gleichartige, parallel angeordnete Schaltungsteile für das Abschalten (unterer Teil) und das Einschalten (oberer Teil).

Beide Teile werden über einen Trennverstärker (mit optischem Eingang) 3 angesteuert. Der untere Teil (zum Abschalten) umfasst eine erste Ansteuerelektronik 1, als Schalter S einen ersten IGBT IG1, einen ersten MOSFET FT1 als Hold-Off-Schalter (mit einer dritten Diode D4 in Serie) und die bereits aus Fig. 5 bekannten Elemente C1, C2, D2, D3.

Der obere Teil (zum Einschalten) umfasst einen zweiten IGBT IG2, einen zweiten MOSFET FT2 als Hold-On-Schalter und entsprechende Elemente C4, C5, D5, D6 und einen zweiten Widerstand R2. Alle Elemente des oberen Teils können gegenüber dem unteren Teil mit reduzierter Belastbarkeit gewählt werden, da für das Einschalten und das Halten im eingeschalteten Zustand deutlich geringere Ströme benötigt werden. Im übrigen ist die Funktion des oberen Teils weitgehend identisch mit der Funktion des unteren Teils.

Insgesamt ergibt sich mit der Erfindung ein hart angesteuerter GTO, der sich durch eine drastische Verringerung des Beschaltungsaufwandes bei gleichzeitiger Reduktion der Schaltverluste auszeichnet.

### BEZEICHNUNGSLISTE

- 1,2: Ansteuerelektronik
- 3: Trennverstärker
- a,..,d: Phase
- A: Anode
- C1,..,C5: Kapazität
- D1,..,D6: Diode
- FT1,FT2: MOSFET
- G: Gate
- GTO: Gate-Turn-Off-Thyristor
- I_{A}: Anodenstrom
- I_{C2}: Strom (an der Kapazität C2)
- I_{C3}: Strom (an der Kapazität C3)
- I_{G}: Gatestrom
- IG1,IG2: IGBT
- I_{K}: Kathodenstrom
- K: Kathode
- L1,..,L4: Induktivität
- p1,..,p5: Phase
- Q: Quelle
- R1,R2: Widerstand
- S: Schalter
- V_{AV}: Avalanchespannung (des GTO)
- V_{C1}: Spannung (an der Kapazität C1)
- V_{G}: Gatespannung
- V_{H,min}: minimale Haltespannung (des GTO)
- V_{H}: Haltespannung
- DELTAQ_{C2}: Ladungsänderung (an der Kapazität C2)
- DELTAQ_{C3}: Ladungsänderung (an der Kapazität C3)

## Patentansprüche

1. GTO-Thyristorschaltung, umfassend
(a) einen über ein Gate abschaltbaren Thyristor GTO mit einer Anode (A), einer Kathode (K) und einem Gate (G);
(b) eine zwischen Gate (G) und Kathode (K) des GTO angeschlossene Ansteuerschaltung, welche zusammen mit dem GTO einen Gatekreis bildet und zum Einschalten und Abschalten des GTO vorgesehen ist; und
(c) innerhalb des Gatekreises eine erste Induktivität (L1) und eine zweite Induktivität (L2), wobei die erste Induktivität (L1) die Induktivität der Leitungen und Elemente in der Ansteuerschaltung repräsentiert, und die zweite Induktivität (L2) die innere Induktivität des GTO selbst darstellt;
(d) im Gatekreis eine erste Kapazität (C1), welche über einen in Serie liegenden Schalter (S) an Gate (G) und Kathode (K) des GTO angeschlossen ist und zusammen mit der ersten und zweiten Induktivität (L1 bzw. L2) einen Serie-Schwingkreis bildet;
(e) eine zur ersten Kapazität (C1) antiparallel geschaltete, erste Diode (D2), welche nach der ersten Viertelschwingung des Serie-Schwingkreises die erste Kapazität (C1) von der Erzeugung des Gatestroms (I_{G}) abkoppelt und den Gatestrom (I_{G}) so langsam abklingen lässt, dass er zu jeder Zeit grösser ist als der Tailstrom des GTO; sowie
(f) zweite Mittel, welche während dem Abklingen des Gatestroms (I_{G}) aktiviert werden und nach dem Abklingen des Gatestroms (I_{G}) das Gate (G) des GTO mit einer für ein Blockieren ausreichenden Haltespannung (V_{H}) beaufschlagen;
dadurch gekennzeichnet, dass
(g) die Grössen der ersten Kapazität (C1) und der ersten Induktivität (L1) so gewählt sind, dass bei einer Entladung der ersten Kapazität (C1) über die beiden Induktivitäten (L1, L2) der aus der ersten Kapazität (C1) stammende Gatestrom (I_{G}) in der ersten Viertelschwingung des Serie-Schwingkreises das 0,5-fache eines abzuschaltenden Anodenstroms (I_{A}) des GTO innerhalb von weniger als 5 µs übersteigt;
(h) die zweiten Mittel eine Serieschaltung aus einer zweiten Kapazität (C2) und einer zweiten Diode (D3) umfassen, welche Serieschaltung zur ersten Kapazität (C1) parallel oder in Serie geschaltet ist.

2. Schaltung nach Anspruch 2, dadurch gekennzeichnet, dass die Grössen der ersten Kapazität (C1) und der ersten Induktivität (L1) so gewählt sind, dass bei einer Entladung der ersten Kapazität (C1) über die beiden Induktivitäten (L1, L2) der aus der ersten Kapazität (C1) stammende Gatestrom (I_{G}) in der ersten Viertelschwingung des Serie-Schwingkreises das 0,5-fache eines abzuschaltenden Anodenstroms (I_{A}) des GTO innerhalb von weniger als 2 µs übersteigt.

3. Schaltung nach Anspruch 1 oder 2, dadurch gekennzeichnet, dass die Serieschaltung der zur ersten Kapazität (C1) parallel geschalteten zweiten Mittel zusätzlich einen Widerstand (R1) umfasst, dessen Wert so gewählt ist, dass ein aus der zweiten Kapazität (C2) gespeister Strom einerseits kleiner ist als der maximale Gatestrom (I_{G,max}) und andererseits grösser ist als der Tailstrom des GTO.

4. Schaltung nach einem der Ansprüche 1 bis 3, dadurch gekennzeichnet, dass die zweite Kapazität (C2) beim Abschalten auf die Haltespannung (V_{H}) vorgeladen ist.

5. Schaltung nach einem der Ansprüche 1 bis 4, dadurch gekennzeichnet, dass als Schalter (S) MOSFETs, IGBTs, hart angesteuerte GTOs, feinstrukturierte Thyristoren oder feldgesteuerte Thyristoren verwendet werden.

6. Schaltung nach Anspruch 5, dadurch gekennzeichnet, dass als Schalter (S) eine Parallelschaltung von mehreren IGBTs verwendet wird.

## Claims

1. GTO thyristor circuit comprising
(a) a gate turn-off thyristor GTO having an anode (A), a cathode (K) and a gate (G);
(b) a drive circuit which is connected between gate (G) and cathode (K) of the GTO and which, together with the GTO, forms a gate circuit and is provided for switching the GTO on and off; and
(c) a first inductance (L1) and a second inductance (L2) inside the gate circuit, the first inductance (L1) representing the inductance of the conductors and components in the drive circuit and the second inductance (L2) the internal inductance of the GTO itself;
(d) in the gate circuit, a first capacitor (C1) which is connected to the gate (G) and cathode (K) of the GTO via a switch (S) situated in series and forms, together with the first and second inductance (L1 and L2, respectively), a series oscillatory circuit;
(e) a first diode (D2) which is connected antiparallel with the first capacitor (C1) and uncouples the first capacitor (C1) from the generation of the gate current (I_{G}) after the first quarter oscillation of the series oscillatory circuit and allows the gate current (I_{G}) to decay slowly in such a way that, at any time, it is greater than the tail current of the GTO; and also
(f) second means which are activated during the decay of the gate current (I_{G}) and apply a holding voltage (V_{H}) which is sufficient for blocking to the gate (G) of the GTO after the decay of the gate current (I_{G});
characterized in that
(g) the chosen sizes of the first capacitor (C1) and of the first inductance (L1) are such that, if the first capacitor (C1) discharges via the two inductances (L1, L2), the gate current (I_{G}) originating from the first capacitor (C1) exceeds half the value of a GTO anode current (I_{A}) to be turned off within less than 5 s in the first quarter oscillation of the series oscillatory circuit;
(h) the second means comprise a series circuit composed of a second capacitor (C2) and a second diode (D3), which series circuit is connected in parallel or in series with the first capacitor (C1).

2. Circuit according to Claim 2, characterized in that the chosen sizes of the first capacitor (C1) and of the first inductance (L1) are such that, if the first capacitor (C1) discharges via the two inductances (L1, L2), the gate current (I_{G}) originating from the first capacitor (C1) exceeds half the value of a GTO anode current (I_{A}) to be turned off within less than 2 s in the first quarter oscillation of the series oscillatory circuit.

3. Circuit according to Claim 1 or 2, characterized in that the series circuit of the second means conected in parallel with the first capacitor (C1) additionally comprises a resistor (R1) whose value is chosen in such a way that a current fed from the second capacitor (C2) is, on the one hand, less than the maximum gate current (I_{G,max}) and, on the other hand, greater than the tail current of the GTO.

4. Circuit according to any of Claims 1 to 3, characterized in that the second capacitor (C2) is precharged to the holding voltage (V_{H}) during turn-off.

5. Circuit according to any of Claims 1 to 4, characterized in that MOSFETs, IGBTs, hard-driven GTOs, finely structured thyristors or field-controlled thyristors are used as switches (S).

6. Circuit according to Claim 5, characterized in that a parallel circuit of a plurality of IGBTs is used as switch (S).

## Revendications

1. Circuit à thyristor GTO comportant
(a) un thyristor GTO blocable au moyen d'une gâchette, avec une anode (A), une cathode (K) et une gâchette (G) ;
(b) un circuit de commande connecté entre la gâchette (G) et la cathode (K) du GTO, ce circuit constituant avec le GTO un circuit de gâchette et étant prévu pour débloquer et bloquer le GTO ; et
(c) dans le circuit de gâchette, une première inductance (L1) et une deuxième inductance (L2), la première inductance (L1) représentant l'inductance des liaisons et des éléments du circuit de commande et la deuxième inductance (L2) représentant l'inductance interne du GTO proprement dit;
(d) dans le circuit de gâchette, un premier condensateur (C1) qui est connecté par l'intermédiaire d'un commutateur (S) placé en série, à la gâchette (G) et à la cathode (K) du GTO et qui constitue en association avec la première et la deuxième inductance (L1 respectivement L2), un circuit oscillant série ;
(e) une première diode (D2) branchée en antiparallèle avec un premier condensateur (C1), cette première diode découplant le premier condensateur (C1) de la génération du courant de gâchette (I_{G}) après le premier quart de période du circuit oscillant série et laissant diminuer le courant de gâchette (I_{G}) si lentement qu'il est à tout moment supérieur au courant de queue du GTO ; ainsi que
(f) des seconds moyens qui sont activés pendant la diminution du courant de gâchette (I_{G}) et qui appliquent à la gâchette (G) du GTO, une tension de maintien (V_{H}) suffisante pour un blocage, après la diminution du courant de gâchette (I_{G}) ;
caractérisé en ce que
(g) les valeurs du premier condensateur (C1) et de la première inductance (L1) sont sélectionnées de telle sorte que lors d'une décharge du premier condensateur (C1) à travers les deux inductances (L1, L2), le courant de gâchette (I_{G}) issu du premier condensateur (C1) dépasse dans le premier quart de période du circuit oscillant série, la valeur de 0,5 fois un courant d'anode (I_{A}) du GTO à bloquer en moins de 5 µs ;
(h) les seconds moyens comportent un montage en série constitué d'un deuxième condensateur (C2) et d'une deuxième diode (D3), ledit montage en série étant branché en parallèle ou en série avec le premier condensateur (C1).

2. Circuit selon la revendication 1, caractérisé en ce que les valeurs du premier condensateur (C1) et de la première inductance (L1) sont sélectionnées de telle sorte que lors d'une décharge du premier condensateur (C1) à travers les deux inductances (L1, L2), le courant de gâchette (I_{G}) issu du premier condensateur (C1) dépasse dans le premier quart de période du circuit oscillant série, la valeur de 0,5 fois un courant d'anode (I_{A}) du GTO à bloquer en moins de 2 µs.

3. Circuit selon la revendication 1 ou 2, caractérisé en ce que le montage en série des seconds moyens branchés en parallèle avec le premier condensateur (C1), comportent de plus une résistance (R1) dont la valeur est sélectionnée de telle sorte qu'un courant fourni par le deuxième condensateur (C2) soit d'une part inférieur au courant de gâchette maximal (I_{G,max}) et d'autre part supérieur au courant de queue du GTO.

4. Circuit selon l'une quelconque des revendications 1 à 3, caractérisé en ce que le deuxième condensateur (C2) est préchargé à la tension de maintien (V_{H}) lors du blocage.

5. Circuit selon l'une quelconque des revendications 1 à 4, caractérisé en ce que l'on utilise en tant que commutateur (S), des MOSFET, des IGBT, des GTO à commande dure, des thyristors à structure fine ou des thyristors à commande par effet de champ.

6. Circuit selon la revendication 5, caractérisé en ce que l'on utilise, en tant que commutateur (S), un montage en parallèle de plusieurs IGBT.
